# DEMANDE DE BREVET EUROPEEN

(11) **EP 4 760 410 A1**
(43) Date de publication de la demande: **17.06.2026**
(21) Numéro de dépôt: 24219888.5
(22) Date de dépôt: 13.12.2024
(51) Int. Cl.: G04B 17/06, G01H 13/00, G04D 7/10

(54) **PROCÉDÉ DE FABRICATION D'UN ÉLÉMENT OSCILLANT**

(71) Demandeur: Nivarox-FAR S.A., 2400 Le Locle (CH)
(72) Inventeur: CHASSIN, Geoffrey, 25500 Morteau (FR); CUSIN, Pierre, 1423 Villars-Burquin (CH)
(74) Mandataire: ICB SA

(57) **Abrégé**

Un aspect de l'invention concerne un procédé de fabrication d'un élément oscillant dont une caractéristique structurelle à une valeur prédéterminée, le procédé comportant une étape de détermination (31) d'une valeur d'une caractéristique structurelle d'un élément oscillant (2) formé dans une plaquette (1a, 1b) à partir d'une sous-étape de génération (39) de cette valeur sur la base d'un algorithme prédictif mis en oeuvre par un ordinateur (8) pour effectuer un traitement d'au moins une caractéristique d'une fréquence de résonnance identifiée de l'élément oscillant (2) lorsqu'il est soumis à une excitation vibratoire lors d'une sous-étape de mesure optique (38) et une étape de modification (42) de dimensions dudit élément oscillant (2) à partir d'une correction dimensionnelle calculée sur la base de la valeur de la caractéristique structurelle déterminée.

## Description

### Domaine technique de l'invention

La présente invention se rapporte au domaine de la fabrication de pièces pour l'horlogerie. L'invention concerne plus particulièrement un procédé de fabrication d'un élément oscillant dont une caractéristique structurelle, comme par exemple une raideur, à une valeur prédéterminée.

### Arrière-plan technologique

Dans l'état de la technique, il est connu d'utiliser des procédés de fabrication de éléments oscillants dans des plaquettes qui mettent en oeuvre des techniques de gravure telles que la gravure au laser, la gravure au plasma, la gravure ionique réactive profonde dite DRIE ou encore la gravure humide.

Toutefois, on constate que la mise en oeuvre de tels procédés engendrent classiquement une dispersion géométrique entre les éléments oscillants formés tous selon un même motif dans une même plaquette.

Pour pallier ces inconvénients, des solutions sont proposées dans l'état de la technique en particulier dans les brevets EP 3181938 et EP 3181939 qui décrivent des procédés de fabrication de spiraux.

Dans le brevet EP 3181938 le procédé de fabrication comprend les étapes suivantes : a) on forme un spiral dans des dimensions supérieures aux dimensions nécessaires pour obtenir un spiral d'une raideur prédéterminée, b) on détermine la raideur du spiral formé lors de l'étape a) par mesure de la fréquence du spiral couplé avec un balancier doté d'une inertie prédéterminée, c) on calcule l'épaisseur de matière à retirer pour obtenir le spiral d'une raideur prédéterminée et d) on retire du spiral formé lors de l'étape a) l'épaisseur de matière calculée, les étapes b), c) et d) pouvant être répétées pour améliorer encore la qualité dimensionnelle.

Dans le brevet EP 3181939, le procédé de fabrication comprend les étapes suivantes : a) on forme un spiral dans des dimensions inférieures aux dimensions nécessaires pour obtenir un spiral d'une raideur prédéterminée, b) on détermine la raideur du spiral formé lors de l'étape a) par mesure de la fréquence du spiral couplé avec un balancier doté d'une inertie prédéterminée, c) on calcule l'épaisseur de matière manquante pour obtenir le spiral d'une raideur prédéterminée et d) on modifie le spiral formé lors de l'étape a) pour compenser l'épaisseur de matière manquante, les étapes b), c) et d) pouvant être répétées pour améliorer encore la qualité dimensionnelle.

De tels procédés peuvent être améliorés notamment afin de limiter les contaminations de la plaquette qui peuvent être engendrées lors d'opérations de mesure qu'ils mettent en oeuvre.

Dans ces conditions, on comprend qu'il existe un besoin de trouver des solutions devant conduire à une telle amélioration.

### Résumé de l'invention

Un but de la présente invention est de proposer un procédé de fabrication d'un élément oscillant permettant de répondre aux besoins précités.

L'invention concerne un procédé de fabrication d'un élément oscillant dont une caractéristique structurelle à une valeur prédéterminée, le procédé comportant les étapes suivantes :
a) former dans une plaquette ledit élément oscillant selon des dimensions différentes aux dimensions nécessaires pour obtenir ledit élément oscillant ayant la caractéristique structurelle de la valeur prédéterminée ;
b) déterminer une valeur d'une caractéristique structurelle de l'élément oscillant dans la plaquette à partir d'une sous-étape de génération de cette valeur à partir d'un algorithme prédictif mis en oeuvre par un ordinateur pour effectuer un traitement d'au moins une caractéristique d'une fréquence de résonnance identifiée de l'élément oscillant lorsqu'il est soumis à une excitation vibratoire lors d'une sous-étape de mesure optique ;
d) calculer une correction dimensionnelle à appliquer audit élément oscillant formé, à partir de la valeur de la caractéristique structurelle déterminée ;
e) modifier les dimensions dudit élément oscillant formé, à partir de la correction dimensionnelle calculée pour l'obtention de l'élément oscillant selon des dimensions inférieures aux dimensions nécessaires pour obtenir ledit élément oscillant ayant la caractéristique structurelle de la valeur prédéterminée.

Dans d'autres modes de réalisation :
- l'étape de détermination comprend une sous-étape d'agencement de l'élément oscillant compris dans la plaquette dans un dispositif de détermination d'une valeur de la caractéristique structurelle de l'élément oscillant ;
- la sous-étape d'agencement comprend une phase de détermination d'une portion de mesure de l'élément oscillant susceptible d'apporter une réponse vibratoire significative lorsque l'élément oscillant est soumis à une excitation vibratoire ;
- la sous-étape d'agencement comprend une phase de positionnement de l'élément oscillant dans le module de mesure optique en particulier entre une source laser et un capteur de lumière à photodiode ;
- la sous-étape d'agencement comprend une phase de positionnement de l'élément oscillant relativement au module générateur ;
- l'étape de détermination comprend une sous-étape de configuration d'un faisceau circulaire susceptible d'être émis par la source laser en le focalisant sur un bord de l'élément oscillant ;
- l'étape de détermination comprend une sous-étape d'application d'une excitation vibratoire variable au cours du temps à l'élément oscillant ;
- cette sous étape prévoit une application à l'élément d'oscillant d'un signal d'excitation avec une amplitude suffisante pour induire cette excitation vibratoire et pour être détectée et mesurée de manière précise par le un module de mesure optique ;
- la sous-étape de mesure optique l'ordinateur en étant connecté au module de mesure optique détermine au moins une caractéristique de la fréquence de résonance à partir de données comprenant les spectres d'amplitude et de phase d'oscillation de déplacement de d'une lame de l'élément oscillant en fonction d'une fréquence d'excitation ;
- l'étape de calcul comprend une sous-étape de détermination à partir cette valeur de la caractéristique structurelle déterminée, d'une épaisseur de matière à ajouter ou à retirer à au moins une dimension de cet élément oscillant formé lors de l'étape de formation pour obtenir l'élément oscillant dont la caractéristique structurelle à une valeur prédéterminée.

### Brève description des figures

D'autres caractéristiques et avantages de l'invention apparaîtront plus clairement à la lecture de la description suivante des modes de réalisation particuliers de l'invention, donnés à titre de simples exemples illustratifs et non limitatifs, et des figures annexées, parmi lesquelles :
- la figure 1 est un logigramme relatif à un procédé de fabrication d'un élément oscillant dont une caractéristique structurelle à une valeur prédéterminée, selon les modes de réalisation de l'invention ;
- les figures 2 et 3 sont des vues schématiques de deux plaquettes différentes comprenant chacun un lot d'éléments oscillants ayant été formés en même temps notamment par gravure tous dans ces plaquettes, selon les modes de réalisation de l'invention ;
- les figures 4 et 5 sont des vues schématiques de première et deuxième variantes d'un dispositif de détermination d'une valeur de la caractéristique structurelle de l'élément oscillant comprenant un élément générateur d'une excitation vibratoire dans le corps de cet élément qui est en contact mécanique avec une partie de la plaquette comprenant une extrémité d'attache de cet élément oscillant, et un module de mesure optique d'au moins une caractéristique d'une fréquence de résonnance identifiée de l'élément oscillant, selon les modes de réalisation de l'invention ;
- la figure 6 est une vue schématique à plus grande échelle d'une partie A de la plaquette représentée sur la figure 3 comprenant un élément oscillant, selon les modes de réalisation de l'invention ;
- la figure 7 est une vue schématique d'une troisième variante d'un dispositif de détermination comprenant un élément générateur de cette excitation vibratoire dans le corps de l'élément oscillant qui est sans contact mécanique avec la partie de la plaquette comprenant l'extrémité d'attache de cet élément oscillant, et le module de mesure optique d'au moins une caractéristique d'une fréquence de résonnance identifiée de l'élément oscillant, selon des modes de réalisation de l'invention, et
- la figure 8 est une vue schématique du module de mesure optique d'au moins une caractéristique d'une fréquence de résonnance identifié de l'élément oscillant, selon les modes de réalisation de l'invention.

### Description détaillée de l'invention

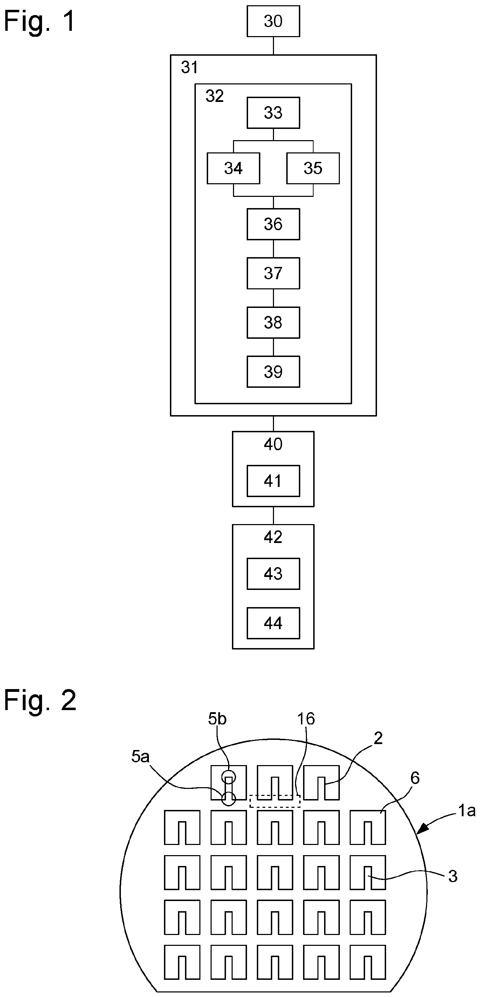

La figure 1 est une représentation schématique du procédé de fabrication d'un élément oscillant 2 dont une caractéristique structurelle a une valeur prédéterminée. Un tel procédé vise à assurer une très haute précision dimensionnelle des éléments oscillants 2 fabriqués et, incidemment, à garantir une caractéristique structurelle plus précise de ces éléments oscillants 2.

Dans ce procédé, l'élément oscillant 2 est configuré pour vibrer à une fréquence stable malgré l'évolution de certains paramètres liés notamment à l'encastrement et au processus de fabrication. Cette fréquence stable varie selon au moins une caractéristique structurelle. Une telle caractéristique structurelle est notamment définie par des caractéristiques vibratoires intrinsèques, comme les fréquences de résonance. Chaque fréquence de résonnance de l'élément oscillant 2 soumis à une force excitatrice, est une fréquence à laquelle on peut mesurer un maximum local d'amplitude de déplacement dans le plan de la plaquette 1a, 1b dans une portion donnée de cet élément oscillant 2. En d'autres termes, si l'élément oscillant 2 est excité avec une source d'excitation de fréquence variable au cours du temps, l'amplitude de déplacement suit une pente ascendante avant cette fréquence de résonnance, et suit une pente descendante après dans cette portion. Typiquement, lors d'un tel essai, l'enregistrement de l'amplitude de déplacement en fonction de la fréquence d'excitation présente un pic d'amplitude de déplacement ou pic de résonnance qui est associé ou qui caractérise la fréquence de résonnance.

Dans ce contexte, une telle caractéristique structurelle peut être une raideur, une épaisseur de lame ou encore le couple élastique.

On notera que dans un mode de réalisation, cet élément oscillant 2 peut être une poutre, une structure de mesure, une éprouvette ou encore un résonnateur mécanique notamment destiné à équiper un organe régulateur d'une montre en ayant la forme d'un ressort spiral en silicium prévu pour équiper un balancier d'un mouvement d'horlogerie mécanique.

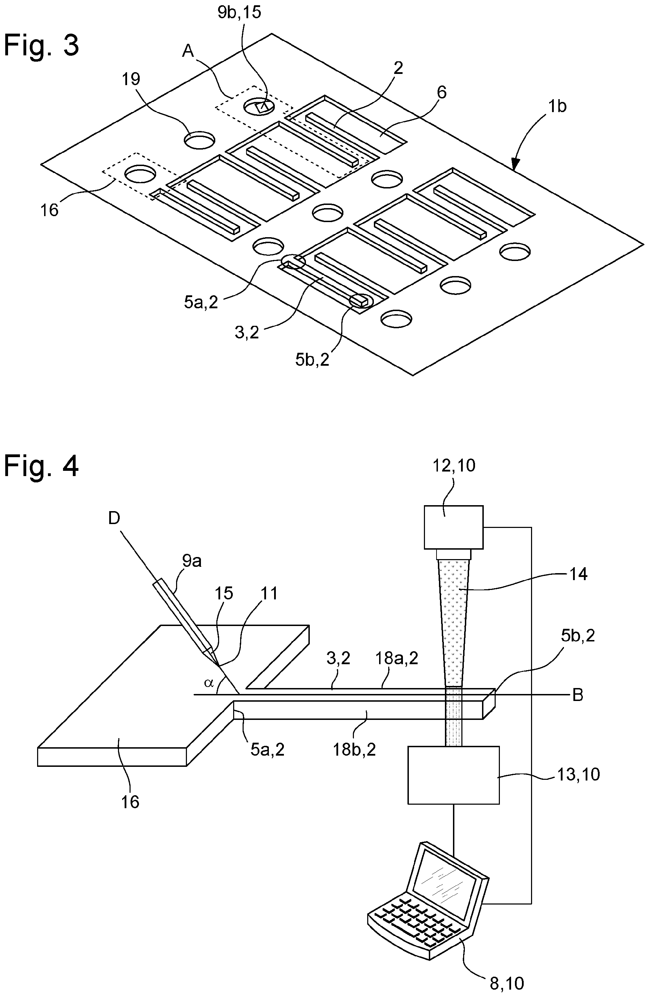

Sur les figures 2 et 3, un lot d'éléments oscillants 2 est compris dans une plaquette 1a, 1b, chacun de ces éléments oscillants 2 a une forme générale d'une poutre. Dans ce lot, chaque élément oscillant 2 comporte une partie élastiquement flexible. Ainsi que nous l'avons évoqué, cet élément peut être un spiral horloger et il comprend alors dans ce contexte un brin élastiquement flexible se raccordant par une extrémité sur une virole et qui est enroulé selon une spirale de manière à former plusieurs spires consécutives, dont la dernière est prolongée par un segment d'attache destiné à être attaché à un pont de balancier fixe, par exemple par l'intermédiaire d'un piton.

En référence à la figure 1, un tel procédé comprend une étape de formation 30 dans la plaquette 1a, 1b du lot d'éléments oscillants. Dans ce lot, chaque élément oscillant 2 a des dimensions différentes des dimensions de l'élément oscillant 2 à fabriquer et qui a une caractéristique structurelle ayant une valeur prédéterminée. En référence à la figue 3, la plaquette 1b comprend un trou traversant 20 formé dans une partie 16 de la plaquette 1b, cette partie 16 comprenant une extrémité d'attache 5a de l'élément oscillant 2 à la plaquette 1b.

Lors de cette étape 30, les éléments oscillants 2 sont formés dans la plaquette 1a, 1b de matière, de préférence simultanément. La formation de chaque élément oscillant 2 dans la plaquette 1a, 1b peut être réalisée par gravure par exemple par gravure ionique réactive profonde, par gravure laser, par gravure chimique ou encore par gravure mettant en oeuvre un faisceau d'ions focalisés. On notera que dans la plaquette 1a, 1b, les éléments oscillants 2 du lot ont de préférence des géométries similaires.

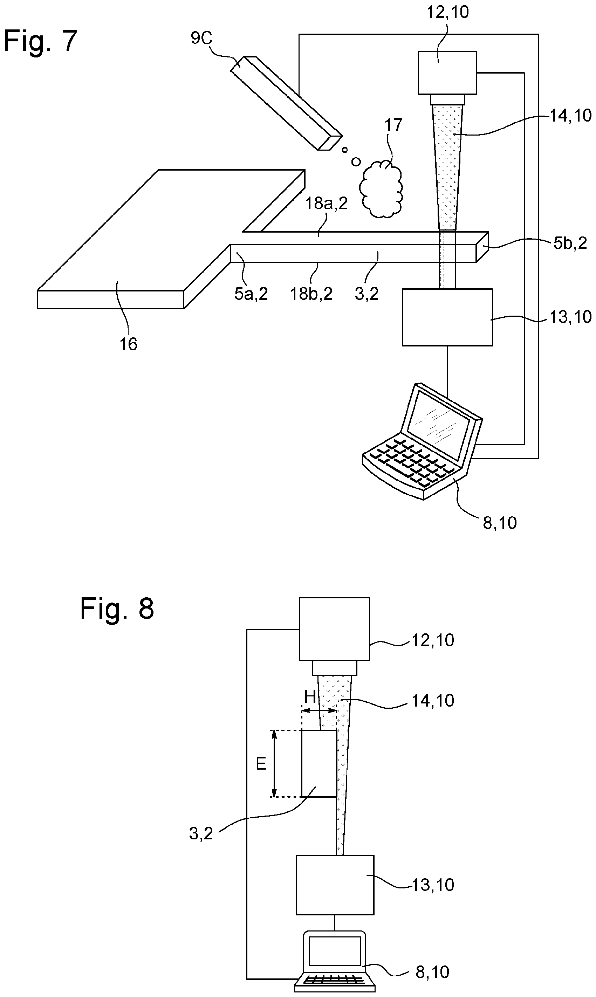

L'élément oscillant 2 formé dans cette plaquette 1a, 1b, comprend au moins une lame 3. En référence à la figure 8, cette lame 3 a une section 4 de dimensions E, H caractérisées par une hauteur H et une épaisseur E de cette section 4 lorsqu'une telle lame 3 est de forme polygonale - qui sont différentes des dimensions correspondantes de l'élément oscillant 2 à obtenir dont la caractéristique structurelle a une valeur prédéterminée. Autrement dit, la lame 3 de cet élément oscillant 2 peut avoir une section 4 dont les dimensions E, H sont supérieures ou inférieures aux dimensions correspondantes de la section 4 de la lame 3 de l'élément oscillant 2 à obtenir et dont la caractéristique structurelle a une valeur prédéterminée.

Dans la plaquette 1a, 1b, la lame 3. Cet élément oscillant 2 comprend une extrémité d'attache 5a et au moins une extrémité libre 5b. Chaque élément oscillant 2 est compris dans une ouverture 6 traversante réalisée dans la plaquette 1a, 1b. Cette ouverture 6 définit un espace dans lequel l'élément oscillant 2 peut exécuter librement un mouvement d'oscillation mécanique commandé/contrôlé dans le plan de la plaquette 1a, 1b.

Dans le contexte de ce procédé, la plaquette 1a, 1b est fabriquée de préférence en silicium dopé ou non. Ce silicium peut être un silicium monocristallin, polycristallin ou amorphe. De plus, ce silicium peut être d'orientation {1,1,1}, {-1,1,1}, {1,-1,1}, {-1,-1,1}. De manière alternative, cette plaquette 1a, 1b peut être fabriquée en verre, en céramique, en nano tubes de carbone, en quartz, en métal ou en alliage.

Ce procédé comprend ensuite une étape de détermination 31 d'une valeur de la caractéristique structurelle de l'élément oscillant 2 formé dans la plaquette 1a, 1b. Lors de cette étape 31, le procédé met en oeuvre un dispositif 7 de détermination de cette valeur.

Ce dispositif de détermination 7 comprend de manière non limitative et non exhaustive :
- un ordinateur 8 ;
- un module générateur 9a, 9b, 9c d'une excitation vibratoire variable au cours du temps dans le corps de l'élément oscillant 2 ;
- un module de mesure optique 10 d'au moins une caractéristique d'une fréquence de résonnance identifiée de l'élément oscillant 2 comprenant une source laser 12 et un capteur de lumière à photodiode 13.

L'ordinateur 8 de ce dispositif de détermination est connecté au module générateur 9a, 9b, 9c et au module de mesure optique. Cet ordinateur 8 comprend au moins un processeur et des éléments de mémoires. Cet ordinateur 8 est apte à exécuter des instructions pour la mise en oeuvre d'un programme d'ordinateur 8 visant par exemple à assurer le pilotage/contrôle des modules d'entrainement et de mesure et aussi des opérations de calcul/traitement lors desquelles au moins un algorithme prédictif, archivé dans les éléments de mémoire, est mis en oeuvre. Cet algorithme peut comprendre un algorithme d'apprentissage automatique et/ou des formules mathématiques. Cet algorithme est apte à mettre en oeuvre un modèle prédictif ou un modèle de simulation permettant de déterminer la valeur de la caractéristique structurelle de l'élément oscillant 2 compris dans la plaquette 1a, 1b à partir de la mesure d'au moins une caractéristique d'une fréquence de résonnance identifié de cet élément oscillant 2 soumis à une excitation vibratoire.

On notera en outre qu'un modèle prédictif mis en oeuvre par cet algorithme, est dans son principe général configuré pour recevoir en entrée des caractéristiques de fréquence de résonnance, et donner en sortie la caractéristique structurelle.

Dans ce dispositif 7, le module générateur 9a, 9b, 9c peut transmettre cette excitation vibratoire au corps de l'élément oscillant 2 en étant en contact mécanique avec une partie 16 de la plaquette 1a, 1b comprenant l'extrémité d'attache 5a de cet élément oscillant 2 ou idéalement sans être en contact avec cette partie 16.

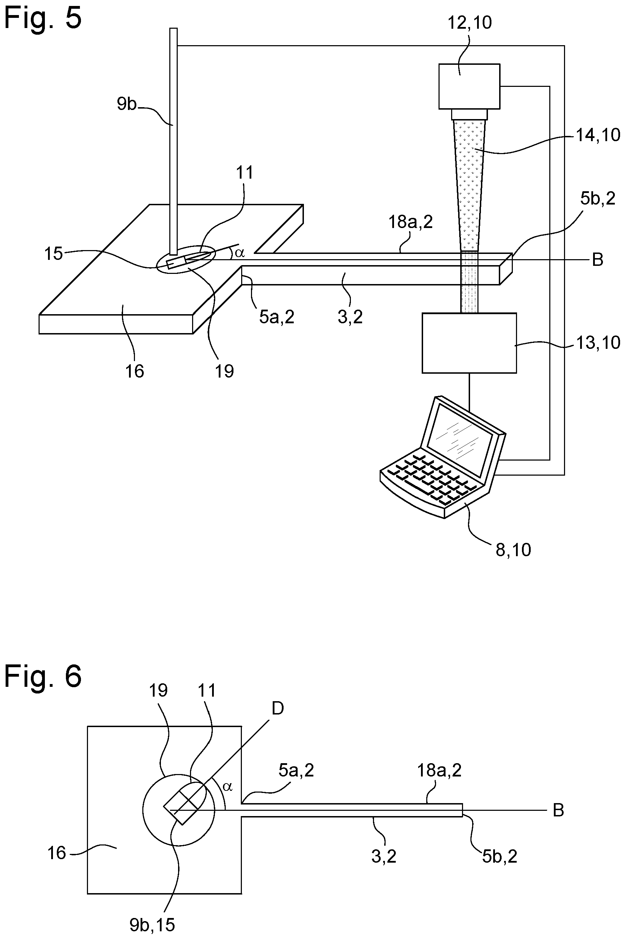

Lorsque ce module générateur 9a, 9b est en contact mécanique avec la plaquette 1a, 1b pour la réalisation d'une excitation vibratoire du corps de cet élément oscillant 2, il comprend un organe de transmission 15 de cette excitation vibratoire pourvu d'une extrémité de contact 11 mécanique qui peut être pointue en ayant la forme d'une aiguille dans une première variante visible sur la figure 4 ou dans une deuxième variante visible sur les figures 3, 5 et 6, d'une extrémité de contact 11 qui peut être arrondie en ayant la forme d'une demi-sphère ou d'un cône. Une telle extrémité est de préférence réalisée en un matériau limitant les potentiels dommages qui pourraient être causés à la plaquette 1a, 1b comme la céramique. Cet organe de transmission 15 est alors configuré pour générer une excitation vibratoire à l'élément oscillant 2 afin d'entrainer le corps de ce dernier dans un mouvement d'oscillation mécanique autour de sa position d'équilibre stable. On notera que cet organe de transmission 15 est apte à générer une telle excitation vibratoire à partir d'une technologie piézoélectrique.

Lorsque ce module générateur 9c est sans contact mécanique avec la plaquette 1a, 1b, il est alors configuré pour générer de l'air pulsé 17 en direction de l'élément oscillant 2 afin d'entrainer le corps de cet élément oscillant 2 dans un mouvement d'oscillation mécanique autour de sa position d'équilibre stable.

Cette étape de détermination 31 comprend une sous-étape d'agencement 32 de la lame 3 de l'élément oscillant 2 compris dans la plaquette 1a, 1b dans le dispositif de détermination 7. Lors de cette sous-étape 32, la lame 3 de l'élément oscillant 2 est positionnée par rapport à la fois au module de mesure optique 10 et au module générateur 9a, 9b, 9c.

Cette sous-étape d'agencement 32 comprend une phase de détermination 33 d'une portion de mesure 20 de la lame 3 de l'élément oscillant 2. Lors de cette phase 33 plusieurs mesures de déplacement d'ondes vibratoires dans le corps de la lame 3 sont effectuées sur différentes portions de cette lame 3 afin d'identifier la portion de mesure 20 qui est susceptible d'apporter une réponse vibratoire significative lorsque le corps de cette lame 3 est soumis à des excitations vibratoires. En effet, une telle phase 33 est nécessaire car lorsque la lame 3 est soumise à une excitation vibratoire, cette dernière peut comprendre des portions dont l'amplitude de déplacement des vibrations, est faible voire nulle surtout lorsque la fréquence varie au cours du temps. Dans le présent mode de réalisation cette portion de mesure 20 est localisée au troisième tiers du corps de la lame 3 qui comprend l'extrémité libre 5b de cette lame 3. Dans le cas de mesure d'organe réglant non rectiligne on cherche à éviter de mesurer dans des noeuds de vibration de la structure.

Par la suite, cette sous-étape d'agencement 32 comprend une phase de positionnement 34 de la portion de mesure 20 de la lame 3 dans le module de mesure optique 10 notamment entre la source laser 12 et le capteur de lumière à photodiode 13. En référence aux figures 4, 5, 7 et 8, la source laser 12 est agencée en regard d'une face supérieure 18a de la lame 3 et le capteur de lumière à photodiode 13 est quant à lui positionné en regard d'une face inférieure 18b de la lame 3. Dans cette configuration la source laser 12 est alignée avec le capteur de lumière à photodiode 13.

Cette sous-étape 32 comprend une phase de positionnement 35 de la lame 3 de l'élément oscillant 2 relativement au module générateur 9a, 9b, 9c. En effet, lorsque l'organe de transmission 15 de ce module générateur 9a, 9b est en contact mécanique avec la plaquette 1a, 1b, son extrémité de contact 11 est alors positionnée de manière à être en liaison mécanique avec la partie de cette plaquette 1a, 1b qui comprend l'extrémité d'attache 5a de l'élément oscillant 2.

Dans ce contexte, la première variante de cet organe de transmission 15, a son extrémité pointue qui est positionnée dans une des zones de la partie 16 définie de part et d'autre de l'axe longitudinale de la lame 3 de manière que l'interface de contact entre la surface de cette zone et celle de l'extrémité pointue ne soit pas agencée sur cet axe ou à proximité immédiate de cet axe.

S'agissant, de la deuxième variante de cet organe de transmission 15, est positionnée dans le trou traversant 19 compris dans la partie 16 comprenant l'extrémité d'attache 5a de l'élément oscillant 2. Dans cette position, l'extrémité de cet organe générateur 9b est alors en contact avec une surface d'une paroi périphérique de ce trou traversant 19.

S'agissant de ces première et deuxième variantes, l'organe 15 est orienté en direction de l'ouverture traversante 6 comprenant cet élément oscillant 2, cette direction formant angle α aigu avec l'axe longitudinale B de la lame 3 de part et d'autre de cet axe B. Un tel angle α est supérieure ou égale à 30 degrés, de préférence compris entre 30 et 50 degrés, de préférence de 45 degrés.

Ainsi que nous l'avons évoqué, l'organe de transmission 15 de ce module générateur 9c peut être sans contact. Dans cette configuration, cet organe de transmission 15 est positionné relativement à la lame 3 de manière à diffuser un flux d'air pulsé 17 en direction de la portion de mesure de la lame 3 exposée au faisceau 14 émis par la source laser 12 du module de mesure optique 10.

Cette étape 31 comprend une sous-étape de configuration 36 du faisceau 14 circulaire émis par la source laser 12. Plus précisément, lors de cette sous-étape 36, le faisceau 14 est focalisé sur un bord 21 de la lame 3, notamment un bord anguleux, localisé dans la portion de mesure 20, visible sur la figure 8. Dans ces conditions, le diamètre du faisceau 14 est configuré pour tenir compte des dimensions de la portion de mesure 20 de la lame 3. Ainsi cette sous-étape 36 participe à améliorer la modulation de la puissance lumineuse de ce faisceau 14 laser susceptible d'être reçu par le capteur de lumière à photodiode 13, par l'amplitude des oscillations de la lame 3. En d'autres termes, la focalisation du faisceau circulaire est configurée pour que l'amplitude des oscillations de la lame 3 dans le plan de la plaquette 1a, 1b ne dépasse le rayon de ce faisceau.

Cette étape de détermination 31 comprend ensuite, une sous-étape d'application 37 d'une excitation vibratoire variable au cours du temps à l'élément oscillant 2. Lors de cette sous étape 37, le module générateur 9a, 9b, 9c applique à la lame 3 de cet élément oscillant 2 un signal d'excitation avec une amplitude suffisante pour induire cette excitation vibratoire et pour être détectée et mesurée de manière précise par le module de mesure optique 10. Ce module générateur 9a, 9b, 9c induit selon :
- un premier mode, une excitation vibratoire entretenue à une seule fréquence donnée, ou
- un deuxième mode, une excitation vibratoire dans le corps de la lame 3 à une fréquence variable dans le temps couvrant une plage fréquentielle prédéterminée. La totalité de cette plage fréquentielle peut être balayée ou couverte dans un intervalle de temps donnée ;
- un troisième mode, combinant alternativement ou successivement ces premier et deuxième modes.

Cette étape 31 comprend une sous-étape de mesure optique 38 d'au moins une caractéristique d'une fréquence de résonnance identifié de l'élément oscillant 2, comme la valeur de cette fréquence de résonnance. Lors de cette sous-étape 38, la puissance lumineuse reçue par le capteur de lumière à photodiode 13 est alors mesurée afin de déduire l'amplitude de la vibration dans la portion de mesure 20 de la lame 3. On notera qu'à la fréquence de résonance, cette amplitude est maximale donc la puissance reçue par ce capteur de lumière 13 est maximum.

Lors de cette sous-étape 38, l'ordinateur 8 en étant connecté à la source laser 12 et au capteur de lumière à photodiode 13 détermine au moins une caractéristique de la fréquence de résonance à partir de données comprenant les spectres d'amplitude et de phase d'oscillation de déplacement de la lame 3 en fonction de la fréquence d'excitation. Ces données sont générées par cet ordinateur 8 à partir d'un enregistrement en fonction du temps de l'amplitude et la phase d'oscillation résultant du faisceau 14 reçu par le capteur de lumière 13.

Une fois ladite caractéristique de cette fréquence de résonance déterminée, l'étape de détermination 31 comprend une sous étape de génération 39 d'une valeur de la caractéristique structurelle dudit élément oscillant 2 compris dans la plaquette 1a, 1b. Lors de cette sous-étape 39, l'ordinateur 8 en exécutant l'algorithme prédictif détermine cette caractéristique structurelle à partir de la caractéristique de la fréquence de résonnance.

Le procédé comprend par la suite une étape de calcul 40 d'une correction dimensionnelle à appliquer à l'élément oscillant 2 à partir de la valeur de la caractéristique structurelle déterminée de cet élément oscillant 2 compris dans la plaquette 1a, 1b. Lors de cette étape 40 une quantification de la correction dimensionnelle à appliquer à l'élément oscillant 2 est alors estimée.

Pour ce faire, cette étape 40 comprend une sous-étape de détermination 41 à partir cette valeur de la caractéristique structurelle déterminée, d'une épaisseur de matière à ajouter ou à retirer à au moins une dimension de cet élément oscillant 2 formé lors de l'étape de formation 30 pour obtenir l'élément oscillant 2 dont la caractéristique structurelle d'une valeur prédéterminée.

Cette correction dimensionnelle correspond effectivement à une épaisseur de matière à retirer ou à ajouter sur l'élément oscillant 2 afin de faire varier au moins une de ses dimensions E, H à savoir :
- uniquement la hauteur H de sa lame 3, ou
- uniquement l'épaisseur E de cette lame 3, ou
- à la fois cette hauteur H et cette épaisseur E.

Cette correction dimensionnelle peut être apportée sur une ou plusieurs longueurs distinctes de la lame 3 ou sur toute la longueur de la lame 3 de cet élément oscillant 2.

Une telle sous-étape 41 permet ainsi par la détermination de la correction dimensionnelle de participer au façonnement d'une géométrie de cet élément oscillant 2 qui va lui conférer une caractéristique structurelle sensiblement similaire ou similaire à la caractéristique structurelle ayant une valeur prédéterminée.

Le procédé comprend ensuite une étape de modification 42 des dimensions E, H de l'élément oscillant 2 à partir d'une correction dimensionnelle calculée pour l'obtention de l'élément oscillant 2 dont la caractéristique structurelle à une valeur prédéterminée.

Dans ce contexte, si les dimensions E, H de cet élément oscillant 2 formé sont supérieures aux dimensions nécessaires pour obtenir l'élément oscillant 2 à fabriquer, cette étape 42 comprend alors une sous-étape de retrait de matière 43 en fonction de l'épaisseur de matière calculer à retirer. Un tel retrait peut alors être réalisé lors d'un processus d'oxydation puis de désoxydation de cet élément oscillant 2 bien connu de l'état de la technique. Une telle sous-étape 43 vise à réduire les dimensions de la section 4 de la lame 3 de cet élément oscillant 2 sur une longueur donnée ou sur toute la longueur de cette lame 3.

Lorsque les dimensions E, H de l'élément oscillant 2 sont inférieures aux dimensions nécessaires pour obtenir l'élément oscillant 2 à fabriquer, cette étape 40 comprend alors une sous-étape d'ajout 44 de matière en fonction de l'épaisseur de matière calculer à ajouter. Un tel ajout de matière peut alors être réalisé lors de processus bien connu de l'état de la technique tels que l'oxydation thermique, la croissance galvanique, le dépôt physique en phase vapeur, le dépôt chimique en phase vapeur, le dépôt en couche atomique ou toute autre processus additif. Une telle sous-étape 44 vise à augmenter les dimensions E, H de la section 4 de la lame 3 de cet élément oscillant 2 sur une longueur donnée ou sur toute la longueur de cette lame 3.

Ainsi un tel procédé permet de corriger avec une grande précision les erreurs dimensionnelles d'éléments oscillants fabriqués par de tels procédés mettant en oeuvre des technologies de photolithographie et/ou de gravure DRIE.

### Nomenclature

1a, 1b. Plaquette comprenant au moins un élément oscillant
2. Elément oscillant
3. Lame de l'élément oscillant
4. Section de la lame de l'élément oscillant aux dimensions différentes à celles correspondantes de la section du spiral à fabriquer
5a. Extrémité d'attache de la lame de l'élément oscillant
5b. Extrémité libre de la lame de l'élément oscillant
6. Ouverture traversante dans la plaquette dans laquelle est agencé l'élément oscillant
7. Dispositif de détermination d'une valeur d'une caractéristique structurelle de l'élément oscillant
8. Ordinateur
9a, 9b, 9c. Module générateur d'une excitation vibratoire variable au cours du temps dans le corps de l'élément oscillant
10. Module de mesure optique d'au moins une caractéristique d'une fréquence de résonnance identifié de l'élément oscillant
11. Extrémité de contact mécanique du module générateur
12. Source laser
13. Capteur de lumière à photodiode
14. Faisceau de la source laser
15. Organe de transmission d'une excitation vibratoire
16. Partie de la plaquette comprenant l'extrémité d'attache
17. Air pulsé par le module générateur
18a. Face supérieure de la lame
18b. Face inférieure de la lame
19. Trou traversant formé dans la partie de la plaquette
20. Portion de mesure de la lame
21. Bord de la portion de mesure

## Revendications

1. Procédé de fabrication d'un élément oscillant (2) dont une caractéristique structurelle à une valeur prédéterminée, le procédé comportant les étapes suivantes :
a) former (40) dans une plaquette (1a, 1b) ledit élément oscillant (2) selon des dimensions différentes aux dimensions nécessaires pour obtenir ledit élément oscillant (2) ayant la caractéristique structurelle de la valeur prédéterminée ;
b) déterminer (31) une valeur d'une caractéristique structurelle de l'élément oscillant (2) dans la plaquette (1a, 1b) à partir d'une sous-étape de génération (39) de cette valeur à partir d'un algorithme prédictif mis en oeuvre par un ordinateur (8) pour effectuer un traitement d'au moins une caractéristique d'une fréquence de résonnance identifiée de l'élément oscillant (2) lorsqu'il est soumis à une excitation vibratoire lors d'une sous-étape de mesure optique (38) ;
d) calculer (40) une correction dimensionnelle à appliquer audit élément oscillant (2) formé, à partir de la valeur de la caractéristique structurelle déterminée ;
e) modifier (42) les dimensions dudit élément oscillant (2) formé, à partir de la correction dimensionnelle calculée pour l'obtention de l'élément oscillant (2) selon des dimensions inférieures aux dimensions nécessaires pour obtenir ledit élément oscillant (2) ayant la caractéristique structurelle de la valeur prédéterminée.

2. Procédé selon la revendication précédente dans lequel l'étape de détermination (31) comprend une sous-étape d'agencement (32) de l'élément oscillant (2) compris dans la plaquette (1a, 1b) dans un dispositif de détermination (7) d'une valeur de la caractéristique structurelle de l'élément oscillant (2).

3. Procédé selon la revendication précédente, dans lequel la sous-étape d'agencement (32) comprend une phase de détermination (33) d'une portion de mesure (20) de l'élément oscillant (2) susceptible d'apporter une réponse vibratoire significative lorsque l'élément oscillant (2) est soumis à une excitation vibratoire.

4. Procédé selon l'une quelconque des revendications 2 et 3, dans lequel la sous-étape d'agencement (32) comprend une phase de positionnement (34) de l'élément oscillant (2) dans le module de mesure optique (10) en particulier entre une source laser (12) et un capteur de lumière à photodiode (13).

5. Procédé selon l'une des revendications 2 à 4, dans lequel la sous-étape d'agencement (32) comprend une phase de positionnement (35) de l'élément oscillant (2) relativement au Module générateur (9a, 9b, 9c).

6. Procédé selon l'une des revendications 4 et 5, dans lequel l'étape de détermination (31) comprend une sous-étape de configuration (36) d'un faisceau (14) circulaire susceptible d'être émis par la source laser (12) en le focalisant sur un bord (21) de l'élément oscillant (2).

7. Procédé selon la revendication précédente, dans lequel l'étape de détermination (31) comprend une sous-étape d'application (37) d'une excitation vibratoire variable au cours du temps à l'élément oscillant (2).

8. Procédé selon la revendication précédente, dans lequel cette sous étape (37) prévoit une application à l'élément d'oscillant (2) d'un signal d'excitation avec une amplitude suffisante pour induire cette excitation vibratoire et pour être détectée et mesurée de manière précise par le un module de mesure optique (10).

9. Procédé selon l'une quelconque des revendications précédentes, dans lequel lors de la sous-étape de mesure optique (38) l'ordinateur (8) en étant connecté au module de mesure optique (10) détermine au moins une caractéristique de la fréquence de résonance à partir de données comprenant les spectres d'amplitude et de phase d'oscillation de déplacement de d'une lame (3) de l'élément oscillant (2) en fonction d'une fréquence d'excitation.

10. Procédé selon l'une quelconque des revendications précédentes, dans lequel l'étape de calcul (40) comprend une sous-étape de détermination (41) à partir cette valeur de la caractéristique structurelle déterminée, d'une épaisseur de matière à ajouter ou à retirer à au moins une dimension de cet élément oscillant (2) formé lors de l'étape de formation 30 pour obtenir l'élément oscillant (2) dont la caractéristique structurelle à une valeur prédéterminée.
